(19) Europäisches Patentamt
European Patent Office
Office européen des brevets

(11) EP 0 854 579 A2

(12) EUROPÄISCHE PATENTANMELDUNG

(43) Veröffentlichungstag:
22.07.1998 Patentblatt 1998/30

(51) Int. Cl.⁶: H03M 1/08

(21) Anmeldenummer: 98100976.4

(22) Anmeldetag: 21.01.1998

(84) Benannte Vertragsstaaten:
AT BE CH DE DK ES FI FR GB GR IE IT LI LU MC
NL PT SE
Benannte Erstreckungsstaaten:
AL LT LV MK RO SI

(30) Priorität: 21.01.1997 DE 19701844

(71) Anmelder: MOTOROLA, INC.
Schaumburg, IL 60196 (US)

(72) Erfinder: Gebauer, Thomas
71573 Allmersbach I. Tal (DE)

(74) Vertreter:
Richardt, Markus Albert
Motorola GmbH,
Hagenauerstrasse 47
65203 Wiesbaden (DE)

(54) **Filter zur Störsignalunterdrückung**

(57) Es wird eine Schaltung zur Umsetzung eines analogen Signals in ein Digitalsignal mit Unterdrückung von Störsignalen vorgeschlagen, die in der Lage ist durch Rückkopplung von Störungen, die aufgrund von Unterabtastung und Digitalisierung auftreten in einem Schleifenfilter Nutz- und Störsignal einmal durchzulassen bzw. zu unterdrücken.

## Fig. 3

**Beschreibung**

Stand der Technik

Die Erfindung geht aus von einer Schaltung zur Umsetzung eines analogen Signals in ein Digitalsignal sowie einem Verfahren zur Umsetzung eines analogen Signals in ein Digitalsignal nach der Gattung der unabhängigen, Ansprüche.

Aus der US-A 4,857,928 ist eine Schaltung für ein Filter bekannt, das zeitkontinuierliche analoge Signale in digitale Signale wandelt und gleichzeitig das Quantisierungsrauschen minimiert. Die Schaltung besteht aus einem Inter-Frequency-Filter zur Unterdrückung der Überfaltungsanteile mit zwei hintereinander geschalteten Bandpaßfiltern und einer Digitalisierungseinheit in einem Signalzweig, sowie einem Rückkopplungszweig zum Summationspunkt einer Digital/Analog-Wandlung. Das analoge Signal nach der zweiten Filterung wird mit dem 32-fachem der Mittenfrequenz des Bandpasses abgetastet (Mittenfrequenz 450 kHz, Abtastfrequenz 14,4 MHz).

Bei einem solchen Sigma-Delta-Demodulator für kontinuierliche analoge Bandpaßsignale müssen bei sehr hochfrequenten schmalbandigen Signalen (MHz-Bereich) die Abtastraten sehr groß sein. Die hohe Abtastfrequenz macht eine anschließende digitale Signalverarbeitung ,z.B. das Herausfiltern von Störkomponenten unmöglich.

Vorteile der Erfindung

Die erfindungsgemäße Schaltung mit den kennzeichnenden Merkmalen des unabhängigen Anspruches hat dagegen den Vorteil, daß die Abtastfrequenz kleiner als die Mittenfrequenz der Bandpaßfilter gewählt werden kann, solange sie größer als zweimal die Nutzbandbreite ist.

Störkanäle, die bis 84 dB oberhalb des Nutzkanals liegen und durch die Abtastung ins Nutzband gefaltet werden, können soweit unterdrückt werden, daß ein Signal-zu-Störabstand bezogen aufs Nutzband von mehr als 14dB erreicht wird. Damit entfallen analoge Vorfilter, mit denen man mit eine Sperrdämpfung von 100dB erreichen müßte. In der Praxis haben selbst teure Quarzfilter eine Sperrdämpfung < 90dB.

Betrachtet man die Weitabselektion eines Filters, so gibt es Frequenzen, bei denen die Sperrdämpfung wieder abnimmt. Die erfindungsgemäße Schaltung hat den Vorteil, daß diese Weitabselektion unkritischer ist.

Der Hauptteil einer solchen Schaltung läßt sich in „Switched-Capacitor"-Technik zusammen mit der digitalen Signalverarbeitung auf einem ASIC verwirklichen (CMOS-Prozeß)

Durch die in den Unteransprüchen aufgeführten Maßnahmen ist eine vorteilhafte Weiterbildung und Verbesserung der im unabhängigen Anspruch angegebenen Schaltung möglich.

Unter gewissen Bedingungen ist es von Vorteil, auf ein Schleifenfilter im Rückkopplungszweig zu verzichten, und so den Aufwand für die Schaltung zu verringern. Es ist weiterhin von Vorteil, daß zur Reduzierung der Überfaltungsanteile, die durch Dezimation in einem nachfolgenden Dezimationsfilter entstehen, eine digitale Dezimationsfilterkette in das System mit eingebaut wird.

Durch geeignete Wahl der Parameter der Schleifenfilter kann es von Vorteil sein, auf das Interpolationsfilter zu verzichten. Dadurch läßt sich die Schaltung noch weiter vereinfachen. Das ursprüngliche Signal ist nach der Digital/Analog-Wandlung, wegen der periodischen Fotsetzung stark gedämpft (sinx/x-Verzerrung) vorhanden.

Es kann von Vorteil sein, bei hohen zu realisierenden Sperrdämpfungen die erfindungsgemäße Schaltung mit Rückkopplungszweig in Teilblöcke zu zerlegen, um die die Stabilität des Regelkreises, zu gewährleisten. Die rückgekoppelten Signale müssen dabei in geeigneter Weise skaliert werden, um die gewünschte Übertragungsfunktion zu realisieren.

Das erfindungsgemäße Verfahren zur Umsetzung eines analogen Signals in ein Digitalsignal hat den Vorteil, daß die Filterfunktionen des Schleifenfilters so gewählt werden können, daß sie bei der Nutzfrequenz einen Pol aufweist. Die Parameter des Filters werden so eingestellt, daß die gesamte Schaltung stabil arbeitet.

Zum Entwurf eines stabilen Systems wird auf das Verfahren in der Veröffentlichung: Design of Stable IIR Filters in the Complex Domain by Automatic Delay Selection, IEEE Transactions on Signal Processing, Vol. 44 No 09 September 1996 hingewiesen.

Hierzu berechnet man die Übertragungsfunktion des Systems H. Alle unstabilen Pole werden gespiegelt ($j\omega$-Achse analoge System/Einheitskreis digitales System). Die neue stabile Übertragungsfunktion H' hat denselben Betragsfrequenzgang, aber eine andere Gruppenlaufzeit. Durch eine digitale Gruppenlaufzeitkorrektur im Rückkopplungskreis kann die gegebene Übertragungsfunktion stabilisiert werden.

Vorteilhafterweise kann im Interpolationsfilter die durch Unterabtastung nicht vorhandenen Signalpunkte durch Nullen aufgefüllt, und das Signal anschließend skaliert werden. Das Interpolationsfilter kann aber auch als Mittelungs- oder M-Bandfilter realisiert sein.

Zeichnung

Ein Ausführungsbeispiel der Erfindung ist in den nachfolgenden Zeichnungen dargestellt und in der Beschreibung näher erläutert. Es zeigt Figur 1 die erfindungsgemäße Schaltung, Figur 2 eine kaskadierte Schaltung, Figur 3 eine spezielle Ausführungsform des Schleifenfilters in der Schaltung, Figur 4 ein Beispiel für einen Schwingkreis, Figur 5 die Darstellung der Übertragungsfunktion und Figur 6 die Darstellung der Bandpaßunterabtastung.

Beschreibung des Ausführungsbeispiels

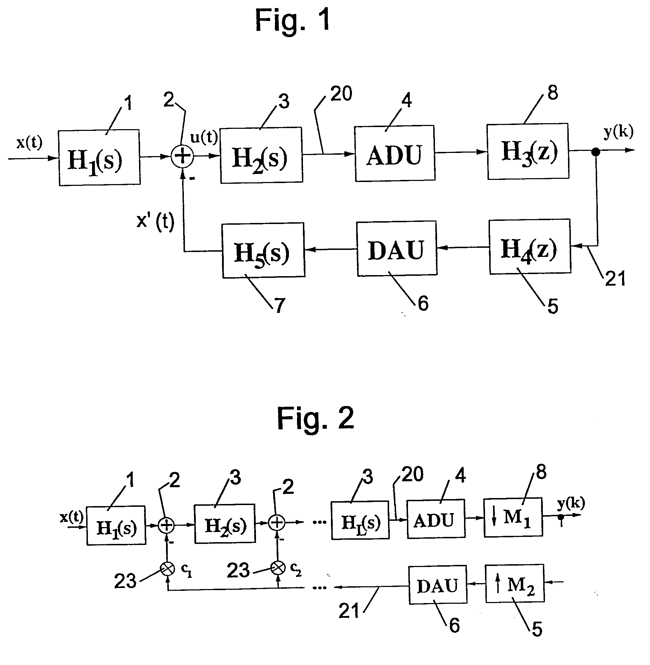

Figur 1 zeigt die erfindungsgemäße Schaltungsanordnung in die das Eingangssignal x(t) eingespeist wird, wobei das Ergebnis der gezeigten Schaltung die Umwandlung des zeitkontinuierlichen Signals in ein zeitdiskretes Signal y(k) ist. Sie besteht aus dem Vorfilter 1, dem Summationsglied 2, den Schleifenfiltern 3, 8 im Signalzweig 20 mit den Analog-Digitalwandler (ADU) 4, sowie den Filtern 5, 7 und dem Digital-Analogwandler (DAU) 6 im Rückkopplungszweig 21. Die Schaltung kann in einem Funkempfänger zur Unterdrückung von starken Störsignalen dienen. Für Funkgeräte mit analoger Sprach-übertragung sind die Kennwerte so festgelegt, daß ein Störkanal 84 dB oberhalb des Nutzkanals liegen kann.

Dieser Störkanal muß soweit unterdrückt werden, daß nach einer Filterung gemäß der Spezifikation DIN ETS 300086 vom Mai 1992 der Nutzsignal-Störabstand größer 14dB ist. Die Filterung muß aber vor der Digitalisierung erfolgen, da durch die Abtastung der Störkanal auf den Nutzkanal gefaltet wird und anschließend durch digitale Filterung nicht mehr eliminiert werden kann. Hierzu wäre ein analoges Vorfilter mit einer Sperrdämpfung von 100dB nötig.

Teure Quarzfilter besitzen aber eine maximale Sperrdämpfung von 90dB. Durch Kaskadierung zweier Teilfilter mit Trennverstärker wäre das Problem lösbar, ebenso mit einer Kaskadierung von Notch-Filtern mit Nullstellen bei Frequenzen, die aufs Nutzband gefaltet werden. Da es aber bei mobilen Funkgeräten (Handys) auch auf das Gewicht bzw. eine kompakte Realisierung ankommt, scheiden diese Alternativlösungen aus.

Die erfindungsgemäße Lösung besitzt auch einen Vorfilter $H_1(s)$ 1, der einen Teil der geforderten Sperrdämpfung realisiert, um das zweite Filter $H_2(s)$ 3 so einfach wie möglich zu machen. Sind die Anforderungen an die Sperrdämpfung nicht so hoch, dann kann auf das Filter 1 verzichtet werden.

Für die weitere prinzipielle Darstellung der Lösung ist er nicht erforderlich.

Das vorverarbeitete Eingangssignal und ein subtrahiertes rückgekoppeltes Signal aus dem Rückkopplungszweig 21 wird am Summationspunkt 2 addiert und auf den Schleifenfilter 3 gegeben. Dieses Filter hat die Aufgabe, im gewünschten Durchlaßbereich des Nutzsignals eine hohe Verstärkung zu gewährleisten. Das Ausgangssignal des Schleifenfilters 3 wird im Analog-Digital-Wandler 4 abgetastet und digitalisiert, wobei Quantisierungsrauschen und Überfaltungsanteile an Nutz- und Störsignal entstehen. Dieser AD-Wandler 4, ebenso wie der DA-Wandler 6 kann ein $\Sigma\Delta$-Wandler realisiert in „Switched-Capacitor"-Technik sein. Er wird dann zusammen mit dem Digitalteil auf einem ASIC integriert. Das Signalgemisch aus Nutzsignal, Störsignal und Überfaltungsanteil, eventuell nach einer Dezimation im Block 8, wird im Rückkopplungszweig 21 zurückgekoppelt.

Da das Signal im AD-Wandler 4 mit einer Abtastfrequenz kleiner als die Durchlaßmittenfrequenz der Bandpässe $H_1(s)$ 1, $H_2(s)$ 3 abgesetzt wird, wird das Nutzsignal in der Frequenz umgesetzt. Dieses Verfahren als Bandpaßunterabtastung bezeichnet, wird später noch erläutert. Im Rückkopplungszweig 21 sollte das Signal wieder in der ursprünglichen Frequenz auf den Signalpunkt 2 subtrahiert werden. Zur Anhebung der Abtastfrequenz werden im Rückkopplungszweig Interpolatoren 5 eingesetzt. Danach passiert das Signal einen Digital/Analog-Wandler (DAU) 6. Falls erforderlich durchläuft das Signal ein weiteres Schleifenfilter 7, das zur Stabilisierung des Regelkreises und Herausfiltern von rückgekoppelten Störkomponenten dient. Am Summationspunkt 2 wird das rückgekoppelte Signal vom Eingangssignal subtrahiert. In den Filtern $H_3(z)$ 8, $H_4(z)$ 5 und $H_5(z)$ 7 kann die Gruppenlaufzeit beeinflußt werden, um die Stabilität des Gesamtsystems zu gewährleisten.

Im Ausgangssignal y(k) kommen Überfaltungsanteile, Quantisierungsanteile und Störsignalanteile im Nutzband nur noch stark gedämpft vor. Die Wirkungsweise der Schaltung ist dadurch gegeben, daß Quantisierungs- und Überfaltungsanteile vom AD-Wandler 4 und Anti-Imaging-Anteile vom Interpolationsfilter 5 hinter dem Schleifenfilter 3 entstehen, während das Eingangssignal u vor dem Schleifenfilter 3 eingekoppelt wird. Das Filter 3 weist im Nutzbereich eine hohe Verstärkung auf. Die Nachbarkanäle, die zur Überfaltung aufs Nutzband beitragen, werden unskaliert durchgelassen. Auf ein Signal mit hoher Verstärkung wird daher ein unskaliertes Signal gefaltet. Der geschlossene Regelkreis begrenzt aber die Ausgangsverstärkung im Nutzband auf 1, so daß durch die Rückkopplung der Überfaltungsanteil im Nutzband stark gedämpft wird. Das Schleifenfilter 3 sowie die Wirkung der Schleife soll im folgenden näher erläutert werden. Die Überfaltung im AD-Wandler wird symbolisch durch Addition einer Störkomponente a(t) aufs Nutzband dargestellt. Danach gestaltet sich die Signalübertragungsfunktion wie folgt:

1. Signalübertragungsfunktion:

$$H_s(s) = \frac{Y(s)}{X(s)} = \frac{H_2(s)}{1+H_2(s)} \qquad (1)$$

2. Störübertragungsfunktion:

$$H_a(s) = \frac{Y(s)}{A(s)} = \frac{1}{1+H_2(s)} \qquad (2)$$

Hat die Übertragungsfunktion $H_2(s)$ mit $s=j2\pi f_{zf}$, $f_{zf}$=Zwischenfrequenz im Nutzband eine sehr hohe Verstärkung, dann geht $H_s(s)$ gegen 1. Das Eingangssignal x(t) wird ungehindert durchgelassen. Für den Überfaltungsanteil, die Störkomponente a(t), die hinter dem Schleifenfilter entsteht, geht die Übertragungsfunktion $H_a(s)$ gegen 0, d. h. aufgrund der hohen Verstärkung des Schleifenfilters im Nutzband wird der Störanteil, der aufs Nutzband gefaltet wird, unterdrückt. Ist die Nutzbandbreite, bezogen zum Abstand des Störers, der unterdrückt werden muß, sehr klein, dann genügt es, einen aktiven Schwingkreis einzusetzen, der eine hohe Verstärkung gewährleistet. Realisiert man einen Schleifenfilter 3 mit zwei Polstellen bei $s_1 = \pm j2\pi f_{zf}$, dann ergibt sich die bekannte Funktion für den Schleifenfilter zu

$$H_2(s) = V\left[\frac{s - s_{01}}{s^2 + (2\pi f_{=f})^2}\right] \qquad (3)$$

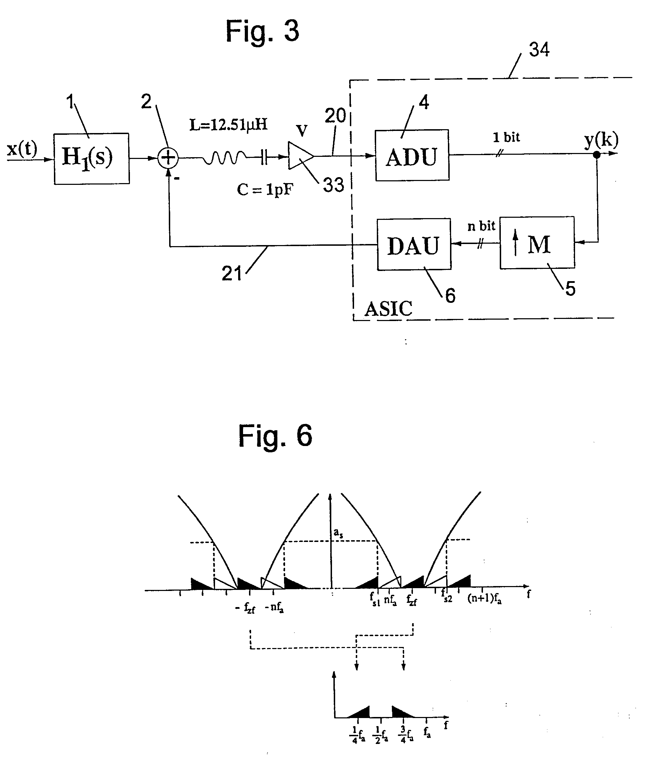

Ein Ausführungsbeispiel für den Fall $s_{01} = 0$ enthält die Fig. 3. Sie zeigt einen vereinfachten Aufbau mit einem Vorfilter 1, von dem aus das Eingangssignal x(t) auf den Summationspunkt 2 gegeben wird. Von dort durchläuft das Signal einen Reihenschwingkreis, bestehend aus einer Spule $L = V/(2\pi f_{zf})^2$ 31 und einem Kondensator $C = 1/V$ 32, sowie einem Innenwiderstand 34. Der Innenwiderstand 34 besteht aus den Widerständen des AD-Wandlers 4 im Signalzweig 20, mit dem der Verstärker 33 verbunden ist, aus dem mit dem AD-Wandler verbundenen Interpolators 5 und dem DA-Wandlers 6, der mit dem Interpolator im Rückkopplungszweig 21 in Verbindung steht und sein Ausgangssignal auf den Summationspunkt 2 bringt. Für diesen idealen verlustfreien Schwingkreis erhält man die Signalübertragungsfunktion

$$H_s(s) = \frac{H_2(s)}{1 + H_2(s)} = \frac{s^2 + \frac{s}{C}}{s^2 + \frac{s}{C} + \frac{1}{LC}} \qquad (4)$$

sowie die Störsignalübertragungsfunktion:

$$H_a(s) = \frac{1}{1 + H_2(s)} = \frac{s^2 + \frac{1}{LC}}{s^2 + \frac{s}{C} + \frac{1}{LC}} \qquad (5)$$

Diese Funktion zeigt eine hohe Sperrdämpfung für alle Überfaltungsbeiträge, die in die Umgebung der angenommenen Zwischenfrequenz fallen. Im Fall eines realen verlustbehafteten Schwingkreises muß die Funktion $H_2(s)$ 3 (Gl. 3) ersetzt werden durch

$$H_2(s) = \frac{VR_L}{sL + 1/sC + R_L + R_s} \qquad (6)$$

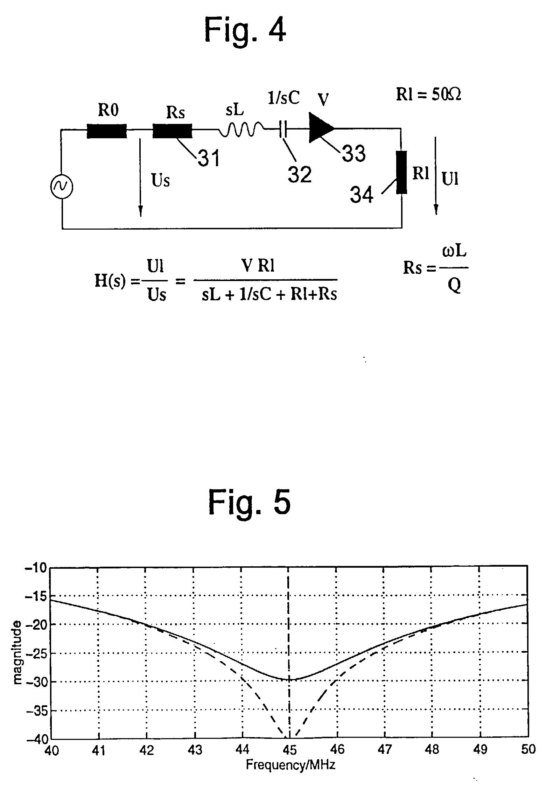

wie sie aus Figur 4 abgeleitet werden kann. Dabei werden spulen- und kondensatorinterne Widerstände $R_s$, sowie der Innenwiderstand des AD-Wandlers und der weiteren Komponenten, wie sie in Fig. 3 im Block 34 dargestellt sind, mit $R_1$ berücksichtigt. Wie Gl. 2 zeigt, ist eine Verstärkung 33 V>1 notwendig, um geeignete Dämpfungen für die Überfaltungsanteile zu erzielen, da für V =1 $H_2(s)$ in Gl. 6 kleiner 1 ist. Figur 5 zeigt die gerechnete Störübertragungsfunktion $H_a$, aufgetragen als Dämpfung über der Frequenz mit den Parametern C=1 F, L=12,51µH, V=100. Die durchgezogene Linie entspricht einer Güte (Q-Wert) von 30, die gestrichelte Linie einer unendlich großen Güte. Mit dieser einfachen Schaltung erzielt man eine Sperrdämpfung von 30dB, d.h. ein Vorfilterpaß $H_1(s)$ mit einer Sperrdämpfung von 70dB wäre ausreichend.

Figur 6 zeigt das Prinzip der Bandunterabtastung. Aufgetragen ist das Signal a über der Frequenz f. Das Nutzsignal liegt bei der Zwischenfrequenz $f_{zf}$. Die Abtastfrequenz wird kleiner als die Bandmittenfrequenz $f_{zf}$ gewählt. Im Beispiel gilt:

$$f_{zf} = (4n+1)\frac{f_a}{4} = (n+\frac{1}{4})f_a \qquad (7)$$

Wegen der periodischen Fortsetzung liegt das Nutzband (Regellage) bei ¼ fa und die Spiegelfrequenz bei ¾ $f_a$ (Mehrlage). Durch diese Bandpaßunterabtastung werden auch benachbarte Spektralanteile (dunkel schraffiert) bei den Frequenzen

$$fi = \left\{....(n-\frac{3}{4})f_a, (n-\frac{1}{4})f_a, (n+\frac{3}{4})f_a, (n+\frac{1}{4})f_a,....\right\} \qquad (8)$$

aufs Nutzband gefaltet. Diese Störkomponenten müssen durch eine analoge Vorfilterung oder durch die erfindungsgemäße Lösung mit einer Sperrdämpfung von $a_s$ unterdrückt werden. Um das analoge Signal wieder rekonstruieren zu können, muß eine Interpolation um den Faktor M=n+1 vorgenommen werden. Das Interpolationsfilter kann durch Einfügen von Nullstellen ins Signal realisiert werden. Der Anti-Imaging-Anteil im Nutzband, der durch die Interpolation entsteht, wird durch die Regelschleife unterdrückt. Durch das Einfügen von Nullstellen wird die Leistung des rückgekoppelten Signals vermindert. Dies kann durch einen Verstärkungsfaktor ausgeglichen werden. Andererseits reicht je nach Problemstellung oft die Schleifenverstärkung auch ohne eine Korrektur aus. Zur Interpolation wird alternativ ein M-Bandfilter oder normales Mittelungsfilter mit der Funktion

$$y(k) = \frac{1}{M}\sum_{i=0}^{M-1} x(k-i) \qquad (9)$$

eingesetzt. Hierdurch wurden dann evtl. verbleibende Anti-Imaging-Anteile weitgehendst unterdrückt. Dadurch vermindert sich der Aufwand für die nachfolgenden Filterstufen, die alle Anteile neben den Nutzbändern wegfiltern sollen. Sind die Systemanforderungen nicht so hoch, kann man durch einfache Überlegung auf das Interpolationsfilter verzichten. Durch die Digital/Analog-Wandlung entsteht aus dem unterabgetasteten Signal eine Treppenkurve. Eine Sinusschwingung

$$x(t) = \sin(2\pi \frac{f_a}{4}) \qquad (10)$$

wird dann modellhaft eine Rechteckfunktion. Diese Funktion ist als Fourier-Reihe darstellbar:

$$x(t) = \frac{4}{\pi} \sum_{i=0}^{\infty} \frac{\sin\left[2\pi(2i+1)\frac{f_a}{4}t\right]}{2i+1} \qquad (11)$$

Da dieses Signalgemisch nach dem Schleifenfilter 3 entsteht, werden alle Anteile außerhalb des Nutzbandes stark unterdrückt, so daß noch idealerweise das skalierte Nutzsignal

$$x_r(t) = \frac{4}{\pi} \frac{\sin\left[2\pi(4n+1)\frac{f_a}{4}t\right]}{4n+1} \qquad (12)$$

zurückgekoppelt wird. Zum selben Ergebnis kommt man auch, wenn man beachtet, daß die periodische Fortsetzung des Digitalsignals durch die D/A-Wandelung erhalten bleibt. Wegen der Treppenkurve kommt noch eine sinx/x-Verzerrung hinzu.

Figur 2 zeigt eine komplexere Struktur des erfindungsgemäßen Demodulators. Das Eingangssignal durchläuft den Vorfilter 1 und wird auf den ersten Summationspunkt 2 gegeben. Daran ist das erste Schleifenfilter 3 angeschlossen, dessen Ausgangssignal den zweiten Summationspunkt 2 passiert und das zweite Schleifenfilter 3 durchläuft. Im weiteren Verlauf des Signalzweigs 20 ist der AD-Wandler 4 mit dem Dezimator 8 verbunden, der an den Ausgang y(k) der Schaltung angekoppelt ist. Der Ausgang ist mit dem Rückkopplungszweig 21, dem Interpolator 5 und dem DA-Wandler 6 verbunden. Der Ausgang des DA-Wandlers ist über den zweiten Skalierer 23 mit dem Summationspunkt 2 und über den ersten Skalierer 23 mit dem Summationspunkt 2 verbunden.
Das Eingangssignal durchläuft den Signalzweig 20 und wird an den Summationspunkten jeweils mit einem Signal aus demm Rückkopplungszweig verknüpft. Das Ausgangssignal y(k) wird nach dem Dezimator 8 ausgekoppelt. Ein Teil des Signals wird in den Rückkopplungszweig 21 rückgekoppelt und durchläuft den Interpolator 5, anschließend den DA-Wandler 6. Bevor ein Teil der Signale aus dem DA-Wandler auf den zweiten Summationspunkt 2 aufgebracht werden, durchlaufen sie die zweite Skalierung 23 und werden mit dem Faktor $c_2$ skaliert. Das weitere Signal aus dem DA-Wandler wird nach Skalierung mit dem Faktor $c_1$ durch den ersten Skalierer 23 auf den ersten Summationspunkt 2 aufgebracht.

Im System können L-Schleifenfilter 3, sowie Summationspunkte 2 und Skalierer 23 eingebaut werden.

Diese Schaltung erhöht die Stabilität des Systems bei mehrfachen Polstellen. Der in den Teilfiltern entstehende Überfaltungsfehler/Anti-Imaging-Fehler im Nutzband wird auch teilweise durch den Rückkopplungszweig 21 ausgeblendet, so daß die Dezimations- bzw. Interpolationsfilter keine so hohe Sperrdämpfung realisieren müssen. Die Dezimation bzw. Interpolation kann in einem Schritt oder stufenweise erfolgen.

**Patentansprüche**

1. Schaltung zur Umsetzung eines analogen Nutzsignals in ein Digitalsignal, mit mindestens einem Schleifenfilter (3) im Signalzweig (20), und einem Rückkopplungszweig (21), dadurch gekennzeichnet, daß sie folgende Bauteile enthält:

    - Summationspunkt (2), an dem ein Eingangssignal (x(t)) ein rückgekoppeltes, analoges Signal (x'(t)) mit negativem Vorzeichen gekoppelt wird,
    - Schleifenfilter (3), auf den das resultierende Signal (u(t)) der Summation gegeben wird,
    - Analog/Digital-Wandler (4) zur Digitalisierung des analogen Signals aus dem Schleifenfilter (3) mit einer Abtastfrequenz kleiner als die Bandmittenfrequenz des Nutzbandes
    - Dezimator (8) und/oder Schaltung zur Gruppenlaufzeitkorrektur der das Signal aus dem Analog/Digital-Wandler (4) verarbeitet, das entstehende Ausgangssignal (y(k)) wird in den Rückkopplungszweig (21) eingespeist, wo
    - eine Schaltung (5) zur Interpolation des digitalen Signals und/oder Schaltung zur Gruppenlaufzeitkorrektur das Signal interpoliert, das im
    - Digital/Analog-Wandler (6) umgesetzt wird und dem
    - Schleifenfilter (7), zugeführt wird, wobei das resultierende Signal (x'(t)) auf den Summationspunkt (2) gekoppelt wird.

2. Schaltung zur Umsetzung eines analogen Nutzsignals in ein Digitalsignal, mit mindestens einem Schleifenfilter (3) im Signalzweig (20) und einem Rückkopplungszweig (21), dadurch gekennzeichnet, daß die Schaltung folgende Bauteile enthält:

- Summationspunkt (2), an dem ein Eingangssignal (x(t)) ein rückgekoppeltes, analoges Signal (x'(t)) mit negativem Vorzeichen gekoppelt wird,
- Schleifenfilter (3), auf den das resultierende Signal (u(t)) der Summation gegeben wird,
- Analog/Digital-Wandler (4) zur Digitalisierung des analogen Signals aus dem Schleifenfilter (3) mit einer Abtastfrequenz kleiner als die Bandmittenfrequenz des Nutzbandes, wobei das entstehende Ausgangssignal (y(k)) in den Rückkopplungszweig (21) eingespeist wird, wo
- eine Schaltung (5) zur Interpolation des digitalen Signals und/oder Schaltung zur Gruppenlaufzeitkorrektur das Signal interpoliert, das im
- Digital/Analog-Wandler (6) umgesetzt wird und dem
- Schleifenfilter (7), zugeführt wird, wobei das resultierende Signal (x'(t)) auf den Summationspunkt (2) gekoppelt wird.

3. Schaltung zur Umsetzung eines analogen Nutzsignals in ein Digitalsignal, mit mindestens einem Schleifenfilter (3) im Signalzweig (20) und einem Rückkopplungszweig (21), dadurch gekennzeichnet, daß die Schaltung folgende Bauteile enthält: (- Summationspunkt (2), an dem ein Eingangssignal (x(t)) ein rückgekoppeltes, analoges Signal (x'(t)) mit negativem Vorzeichen gekoppelt wird,

- Schleifenfilter (3), auf den das resultierende Signal (u(t)) der Summation gegeben wird,
- Analog/Digital-Wandler (4) zur Digitalisierung des analogen Signals aus dem Schleifenfilter (3) mit einer Abtastfrequenz kleiner als die Bandmittenfrequenz des Nutzbandes
- Dezimator (8) und/oder Schaltung zur Gruppenlaufzeitkorrektur der das Signal aus dem Analog/Digital-Wandler (4) verarbeitet, das entstehende Ausgangssignal (y(k)) wird in den Rückkopplungszweig (21) eingespeist, wo
- eine Schaltung (5) zur Interpolation des digitalen Signals und/oder Schaltung zur Gruppenlaufzeitkorrektur das Signal interpoliert, das im
- Digital/Analog-Wandler (6) umgesetzt wird, wobei das resultierende Signal (x'(t)) auf den Summationspunkt (2) gekoppelt wird.

4. Schaltung zur Umsetzung eines analogen Nutzsignals in ein Digitalsignal, mit mindestens einem Schleifenfilter (3) im Signalzweig (20) und einem Rückkopplungszweig (21), dadurch gekennzeichnet, daß die Schaltung folgende Bauteile enthält:

- Summationspunkt (2), an dem ein Eingangssignal (x(t)) ein rückgekoppeltes, analoges Signal (x'(t)) mit negativem Vorzeichen gekoppelt wird,

- Schleifenfilter (3), auf den das resultierende Signal (u(t)) der Summation gegeben wird,
- Analog/Digital-Wandler (4) zur Digitalisierung des analogen Signals aus dem Schleifenfilter (3) mit einer Abtastfrequenz kleiner als die Bandmittenfrequenz des Nutzbandes, wobei das entstehende Ausgangssignal (y(k)) in den Rückkopplungszweig (21) eingespeist wird, wo es
- im Digital/Analog-Wandler (6) umgesetzt wird und wobei das resultierende Signal (x'(t)) auf den Summationspunkt (2) gekoppelt wird.

5. Schaltung zur Umsetzung eines analogen Signals in ein Digitalsignal, mit mindestens einem Schleifenfilter (3) nach einem der vorhergehenden Ansprüche, dadurch gekennzeichnet, daß der Signalzweig (20) mindestens einen Summationspunkt (2) vor jeweils einem Schleifenfilter (3) aufweist, der mit Skalierungseinheiten (23) im Rückkopplungskreis (21) verbunden ist.

6. Schaltung zur Umsetzung eines analogen Signals in ein Digitalsignal nach einem der vorhergehenden Ansprüche, dadurch gekennzeichnet, daß die Dezimation im Dezimator (8) und/oder die Interpolation im Interpolator (5) mit dem Faktor 1 erfolgt.

7. Schaltung zur Umsetzung eines analogen Signals in ein Digitalsignal nach einem der vorhergehenden Ansprüche, dadurch gekennzeichnet, daß die Verstärkung der Schleifenfilterfunktion des Filters (7) groß ist.

8. Schaltung zur Umsetzung eines analogen Signals in ein Digitalsignal nach einem der vorhergehenden Ansprüche, dadurch gekennzeichnet, daß die Filterfunktionen der Schleifenfilter (3,7) einen Pol bei der Nutzfrequenz ($f_{zf}$) aufweisen.

9. Schaltung zur Umsetzung eines analogen Signals in ein Digitalsignal nach einem der vorhergehenden Ansprüche, dadurch gekennzeichnet, daß das Interpolationsfilter (5) bei einer Interpolation um den Faktor M M-1 Nullen in das digitale Signal einfügt und das Signal skaliert.

10. Schaltung zur Umsetzung eines analogen Signals in ein Digitalsignal nach einem der vorhergehenden Ansprüche, dadurch gekennzeichnet, daß das Interpolationsfilter (5) ein Mittelungs- oder M-Bandfilter ist.

11. Schaltung zur Umsetzung eines analogen Signals in ein Digitalsignal nach einem der vorhergehenden Ansprüche, dadurch gekennzeichnet, daß ein analoges Vorfilter (1) zur Dämpfung eines Störsignals des Eingangssignals (x(t)) vor dem Summationspunkt eingebaut ist.

12. Schaltung zur Umsetzung eines analogen Signals in ein Digitalsignal nach einem der vorhergehenden Ansprüche, dadurch gekennzeichnet, daß die Schaltung mindestens ein Gruppenlaufzeitglied zur Sicherung der Stabilität enthält.

# Fig. 1

# Fig. 2

# Fig. 3

# Fig. 6

# Fig. 4

$$H(s) = \frac{Ul}{Us} = \frac{V\,Rl}{sL + 1/sC + Rl + Rs}$$

$$Rs = \frac{\omega L}{Q}$$

# Fig. 5